Europäisches Patentamt

(19) European Patent Office

Office européen des brevets

(11) Numéro de publication : **0 081 424**
**B1**

(12) **FASCICULE DE BREVET EUROPÉEN**

(45) Date de publication du fascicule du brevet :
01.10.86

(51) Int. Cl.⁴ : **H 04 B   1/08, H 04 B   1/16,**
**H 03 J   7/28, H 03 K 17/955**

(21) Numéro de dépôt : **82402183.6**

(22) Date de dépôt : **30.11.82**

(54) Récepteur de radiophonie à dispositif de commande entièrement électronique.

(30) Priorité : 09.12.81 FR 8123029

(43) Date de publication de la demande :
15.06.83 Bulletin 83/24

(45) Mention de la délivrance du brevet :
01.10.86 Bulletin 86/40

(84) Etats contractants désignés :
BE DE FR GB IT NL

(56) Documents cités :
FR-A- 2 355 413
GB-A- 1 587 408
US-A- 3 965 336
FUNKSCHAU, vol. 49, no. 22, octobre 1977, pages
1020-1024, Munich, DE., "Auto- und Reiseempfänger.
Die "Kleinen" mausern sich"
NACHRICHTEN ELEKTRONIK, vol. 31, no. 11, novembre 1977, pages 313-315, Berlin, DE., G. DICKOPP:
"Entwicklungstendenzen in der Hörrundfunk-Empfangstechnik"
IEEE TRANSACTIONS ON BROADCAST AND TELEVI-
SION RECEIVERS, vol. BTR 20, no. 4, novembre 1974,
pages 299-310, New York, USA, G. WHELPLEY: "Solid
state audio control"

(73) Titulaire : SOCIETE D'ELECTRONIQUE INDUS-
TRIELLE D'ELBEUF ELINDEL
186, rue du Faubourg Saint-Honoré
F-75008 Paris (FR)

(72) Inventeur : Froeliger, Denis
THOMSON-CSF SCPI 173, bld Haussmann
F-75379 Paris Cedex 08 (FR)

(74) Mandataire : Grynwald, Albert et al
THOMSON-CSF SCPI 19, avenue de Messine
F-75008 Paris (FR)

## Description

La présente invention concerne des récepteurs de radiophonie, c'est-à-dire des récepteurs d'ondes électromagnétiques radiodiffusées, modulées à l'émission par un signal sonore ou audio-fréquence en amplitude ou en fréquence, notamment l'agencement de leurs dispositifs de commande. Elle se rapporte, plus particulièrement à des récepteurs dits « radio », notamment à ceux destinés à être montés dans des véhicules automobiles, dits « auto-radio », et à leurs dispositifs de commande, dépourvus de tout composant mécanique.

Dans les récepteurs « radio » et « auto-radio » classiques, les dispositifs de commande comprennent, notamment, un commutateur « marche-arrêt » qui est soit couplé à l'axe commandant le potentiomètre de réglage du volume, qui doit être tourné, soit commandé par un bouton-poussoir, un potentiomètre de réglage du volume à axe tournant ou à translation rectiligne, un élément d'accord réactif des circuits résonnants radio-fréquence et de l'oscillateur local comprenant plusieurs réactances simultanément variables, tels que des condensateurs d'accord multiples, fixés sur un même axe ou des inductances à noyaux axialement mobiles à commande mécaniquement couplée, et des commutateurs de gammes d'ondes rotatifs, à boutons-poussoirs ou à touches. Tous ces éléments, ainsi que l'indicateur d'accord avec son cadran, sont généralement à commande mécanique et ceux à axes tournants sont manipulés par l'utilisateur au moyen de boutons de réglage tournants qui dépassent de la façade (face avant) orientée vers celui-ci.

Les éléments à commande mécanique, tels que les potentiomètres de réglage du volume ou de tension d'accord, lorsque les éléments à réactance variable sont constitués par des diodes à capacité variable (« varicap ») en fonction de leur tension de polarisation inverse, les condensateurs rotatifs multiples ou les bobines à noyau mobile, constituent des sources de pannes mécaniques et/ou électriques (faux contacts) et ils sont sujets à l'usure.

En ce qui concerne les récepteurs destinés à être montés à bord de véhicules automobiles avec des commandes devant rester accessibles au conducteur, sont généralement contenus dans un boîtier qui peut être inséré dans une ouverture pratiquée dans le tableau de bord, par exemple. Les parties saillantes qui dépassent de la façade du récepteur, telles que les boutons de commande tournants, sont susceptibles d'occasionner des blessures au conducteur et/ou aux passagers du véhicule, notamment lors des brusques décélérations de celui-ci. Par ailleurs, les boutons de commande tournants, les poussoirs et les indicateurs de station rendent la présence d'un auto-radio classique aisément repérable à d'éventuels voleurs.

L'invention permet de remédier aux inconvénients énumérés ci-dessus, en utilisant des éléments de commande et d'indication statiques, entièrement électroniques, en remplacement des éléments nécessitant une transmission mécanique entre l'extérieur et l'intérieur du boîtier.

L'invention a pour objet un récepteur radiophonique pour véhicule automobile à dispositifs de commande entièrement dépourvu d'éléments mécaniques.

Suivant l'invention, le dispositif de commande de ce récepteur est agencé de telle sorte que sa façade ou face avant accessible à l'utilisateur est dépourvue de saillies, de creux ou d'aspérités notables, et lorsque le récepteur est arrêté, cette façade présente un aspect sensiblement lisse et opaque.

L'invention concerne donc un récepteur de radiophonie destiné à être monté à poste fixe, à bord d'un véhicule automobile, dont les circuits sont contenus à l'intérieur d'un boîtier fermé comprenant une face avant ou façade pouvant rester seule accessible à l'utilisateur en vue de commander diverses fonctions du récepteur, telles que sa mise en route, son arrêt, la recherche automatique de stations émettrices, la commutation de gammes de fréquences et/ou du type de modulation de l'onde porteuse reçue et l'intensité du volume sonore. Un récepteur connu de ce type est décrit par exemple dans l'article intitulé « Auto- und Reiseempfänger. Die « Kleinen » mausern sich », pages 1020 à 1024 de la Revue Funkschau, volume 49, n° 22, Octobre 1977. Le récepteur de l'invention est caractérisé en ce que la façade comporte une plaque transparente teintée avec des zones sensibles pour commander toutes les fonctions du récepteur et des zones pour afficher les informations telle que la fréquence d'une station reçue, et en ce que le récepteur comporte des moyens émetteurs de lumière à l'arrière de la façade, c'est-à-dire à l'intérieur du boîtier, pour afficher les zones de commande et les zones d'affichage lorsque le récepteur est en fonctionnement, ladite plaque frontale teintée étant telle qu'elle reste opaque, lesdites zones étant pratiquement invisibles, lorsque les moyens émetteurs de lumière ne fonctionnent pas.

Dans un mode de réalisation chaque zone de commande comprend, sur la face arrière de la plaque frontale, une partie qui est plus transparente que le reste de cette zone de sorte que cette partie à plus grande transparence apparaisse plus claire que son environnement quand les moyens émetteurs de lumière sont en fonctionnement, cette partie étant un symbole représentant la fonction de cette zone de commande. Cette partie la moins transparente de la zone de commande est dans un exemple recouverte, sur ladite face arrière de la plaque de façade, d'une couche métallique. Dans ce cas cette couche métallique peut être utilisée pour former une électrode d'un condensateur, la zone de commande fonctionnant comme une touche à effet de proximité capacitif coopérant avec une partie, tel qu'un doigt, du corps de l'utilisateur. Une telle touche est connue en soi, par exemple par GB-A-1 587 408.

Dans un mode de réalisation connu en soi (voir DE-A-2 036 840) de ce dispositif de commande la couche conductrice de chaque touche est reliée à l'une des bornes de l'enroulement de réaction d'un oscillateur à transistor dont le collecteur est relié à un circuit résonnant parallèle et qui se met à osciller, lorsqu'une partie du corps de l'utilisateur se trouve capacitivement couplée à cette couche, de manière suffisante.

L'onde fournie par l'oscillateur est transmise par l'intermédiaire d'un montage redresseur à au moins un basculeur bistable de telle sorte que, par exemple, la transition correspondant à la mise en route de l'oscillateur commande le basculement de celui-ci dans un état prédéterminé, à condition qu'il ait été antérieurement dans un état complémentaire à ce dernier. Pour certaines touches, le signal rectangulaire fourni par le redresseur pendant l'oscillation de l'oscillateur, dû à une présence prolongée d'un doigt de l'utilisateur à sa proximité, est appliqué à au moins une porte logique de coïncidence (du type « ET » ou « NON-ET »), soit afin de laisser passer des impulsions récurrentes provenant d'une horloge incorporée, soit afin de refermer un circuit de réaction d'un multivibrateur astable engendrant d'autres impulsions récurrentes, au cours de la durée de ce signal.

Dans un mode de réalisation du dispositif d'accord du récepteur dans lequel les circuits résonnants accordables du récepteur (équipant l'étage de ce circuit d'entrée radio-fréquence et l'oscillateur local) sont munis de diodes à capacité variable, les tensions d'accord de ces diodes sont fournies à l'aide d'un dispositif de recherche automatique comprenant une horloge fournissant des signaux rectangulaires récurrents, une autre porte de coïncidence commandée au moyen d'un autre basculateur bistable dont le basculement dans un état rendant la porte passante, est commandé par l'une des touches et dont le basculement de cet état dans son état complémentaire, commandant le blocage de la porte, est commandé par une impulsion ou transition provenant du circuit récepteur, indiquant la réception d'une onde porteuse d'amplitude supérieure à un seuil prédéterminé, un compteur binaire dont l'entrée d'horloge est alimentée par l'autre porte et un convertisseur numérique-analogique sous la forme d'un réseau de résistances, alimenté par les sorties parallèles du compteur et fournissant une forme d'onde de tension en marches d'escalier pendant que cette autre porte est passante.

L'invention sera mieux comprise et d'autres de ses objets, caractéristiques et avantages ressortiront de la description qui suit et des dessins ci-annexés s'y rapportant, donnés à tire d'exemple, sur lesquels :

la figure 1 est une vue frontale d'un premier mode de réalisation de la façade suivant l'invention du récepteur arrêté ;

la figure 2 est une vue en perspective du boîtier de ce récepteur muni d'un second mode de réalisation de la façade, lorsqu'il est en état de marche ; et

la figure 3 est un schéma de principe d'un mode de réalisation du dispositif de commande entièrement électronique d'un tel récepteur « auto-radio ».

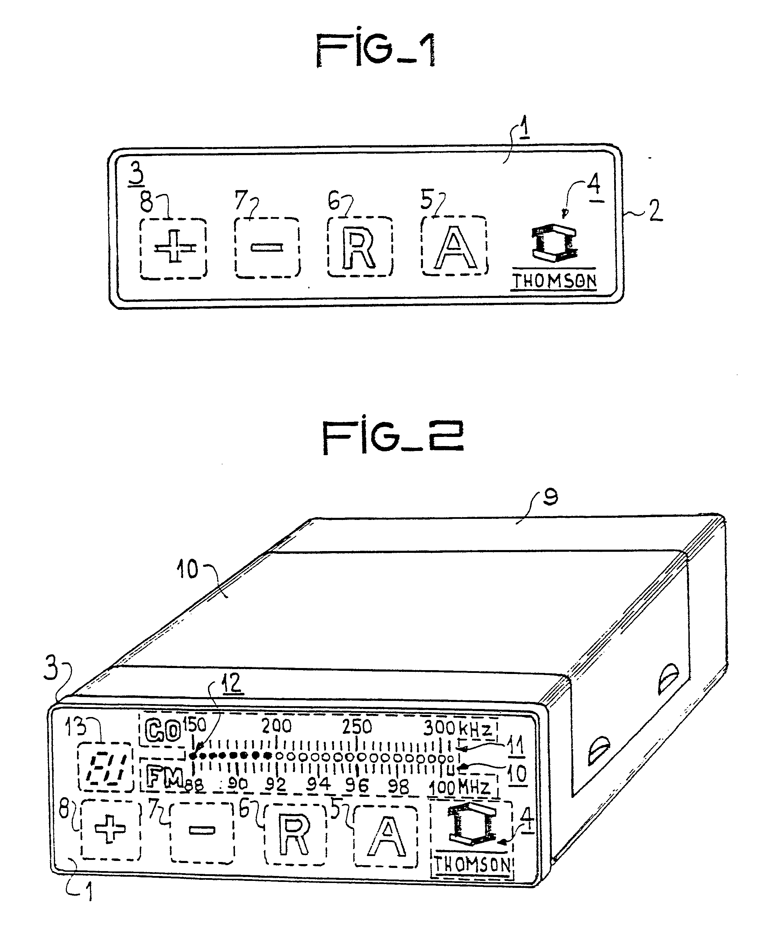

Sur la figure 1, on a représenté en 1 la façade ou face avant du récepteur « auto-radio » qui est destiné à être monté sur le tableau de bord d'un véhicule automobile de telle sorte qu'elle est sensiblement au ras de la surface de ce tableau ou, éventuellement, placée dans une cavité peu profonde de celui-ci. Dans ce mode de réalisation elle est entourée d'un cadre 2 rectangulaire qui sert à retenir la façade 1 en place, par exemple, au moyen d'une gorge (non représentée) pratiquée. sur son pourtour intérieur. L'arrière du cadre 2 est rendu solidaire de la circonférence du boîtier métallique de forme parallélépipédique (non représenté) du récepteur.

Il peut être avantageux de réaliser le cadre 2 en matériau plastique ayant une certaine élasticité pour permettre le retrait relativement aisé de la façade 1, qui en découvrant la face avant (non représentée) du boîtier du récepteur, occultée par elle, permet le remplacement de toutes les lampes de signalisation et d'éclairage incandescentes, lorsqu'elles deviennent défectueuses.

La façade 1 constitue la face avant d'une plaque rectangulaire rigide 3 en un matériau isolant teinté, c'est-à-dire en un matériau plastique (résine) transparent auquel est mélangé un colorant d'une teinte relativement foncée. Ceci permet, d'une part, d'atténuer la lumière provenant des lampes susmentionnées pour éviter de gêner ou d'éblouir le conducteur et d'autre part, de lui rendre un aspect opaque, difficilement discernable de son environnement, lorsqu'elle est éclairée uniquement de l'extérieur. Le matériau transparent utilisé est, de préférence, une résine acrylique tel que le méthacrylate de polyméthyl.

Dans le coin inférieur droit, la façade 1 peut porter la marque du constructeur ou du distributeur 4 qui peut être obtenue, par exemple, par une métallisation ou la peinture de la face avant ou de la face arrière de la plaque teintée. Dans le second cas elle doit être éclairée par derrière pour devenir visible.

Sur la figure 1, on a représenté en pointillé quatre zones sensibles ou touches à effet de proximité ou à couplage capacitif, respectivement désignées par 5, 6, 7 et 8. A l'endroit de ces zones sensibles 5-8, l'épaisseur de la plaque 3 doit être réduite par des creux (cavités) pratiqués, de préférence, dans sa face arrière et, éventuellement, dans sa face avant ou dans les deux, soit lors du coulage ou moulage de la pièce ou par la suite, par usinage.

Les quatre zones ou touches sensibles 5-8 (en creux) représentées sont de forme sensiblement carrée et disposées de manière équidistante le long d'un axe parallèle à l'axe longitudinal de la plaque rectangulaire 3. Elles peuvent également être rectangulaires, circulaires ou elliptiques, ou de tout autre forme géométrique.

Les faces arrière respectives de ces zones amincies sont métallisées, c'est-à-dire recouvertes chacune sur la majeure partie de leur surface d'une couche de métal qui, si elle est opaque, comporte quelques lacunes en forme de symboles (+, —) ou de lettres (R, A) permettant de les rendre visibles par un éclairage par l'arrière, réalisé au moyen de lampes disposées derrière ces zones qui sont en outre délimitées par des cloisons opaques en saillie de la face avant du boîtier, pour que chacune n'en éclaire qu'une seule touche. Ces lettres et symboles indiquent les fonctions (arrêt, recherche, réduction ou accroissement du volume sonore) que chacune des touches 5-8 commande. Les surfaces métallisées sont isolées l'une de l'autre.

Lorsque la métallisation est transparente, les zones qui ne sont pas destinées à être illuminées par transparence peuvent être recouvertes d'une couche de peinture opaque. Dans ce cas, il est possible d'éclairer la zone sensible dans sa totalité et le symbole ou la lettre indiquant la fonction peut être opaque.

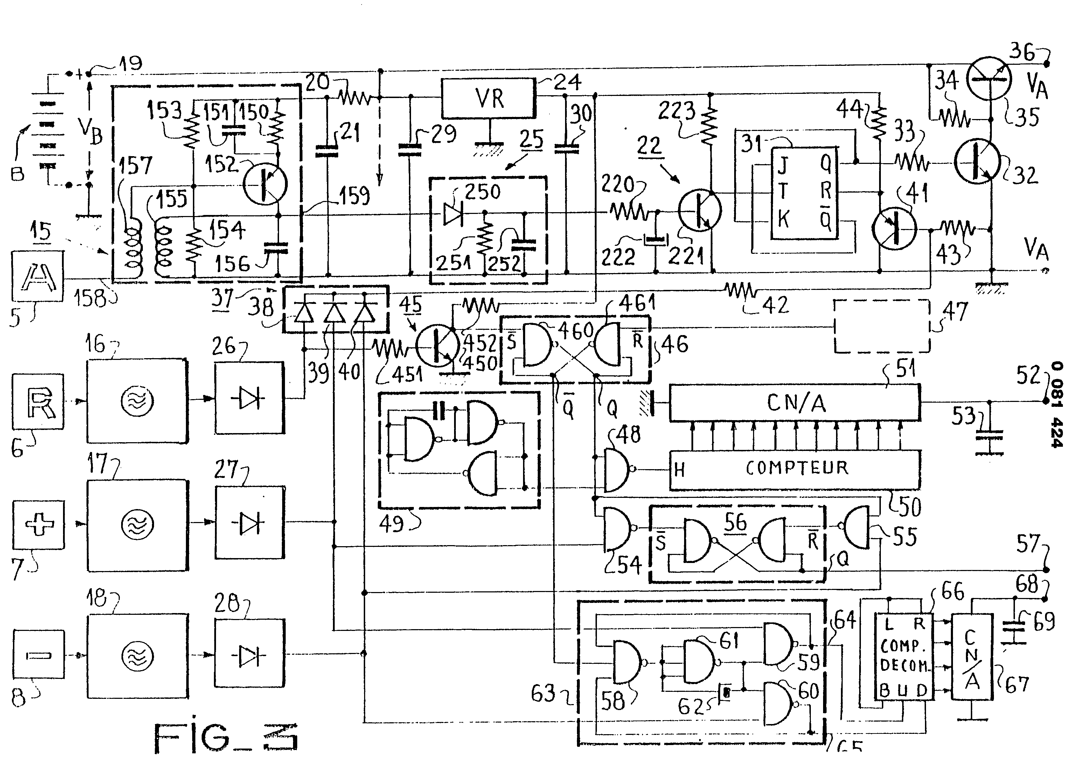

Sur la figure 2, on a représenté en perspective le boîtier parallélépipédique 9 contenant les circuits de réception et de commande, dont la face avant est recouverte d'une plaque rectangulaire 3 selon un second mode de réalisation de l'invention.

Les faces arrière, du dessous, du dessus et latérales du boîtier 9 sont en un métal bon conducteur (tôle), afin de constituer un écran aux signaux parasites provenant de l'allumage et/ou d'autres sources parasites intérieures ou extérieures au véhicule. Il peut être avantageux de le munir d'un couvercle métallique amovible 10 pour permettre d'accéder aux circuits électroniques pour leur dépannage éventuel.

La plaque 3 est munie sur sa partie supérieure de sa face avant de deux zones d'affichage 10 et 11 superposées et respectivement munies de gradations (traits verticaux) et de nombres alignés, ainsi qu'à la fin de chaque ligne de ces derniers, de l'indication des unités (MHz et kHz) se rapportant à ces nombres. Du côté opposé à celui des unités, chaque zone d'affichage comprend une désignation de la gamme d'ondes reçues (GO et FM). Ces indications (gradations, chiffres et lettres) peuvent être affichés par contraste avec leur environnement , les uns étant opaques et les autres transparents et colorés ou l'inverse. Les deux zones d'affichage 10 et 11 sont délimitées à l'intérieur par des saillies opaques de telle sorte qu'elles soient éclairées alternativement selon la gamme d'ondes reçues. Dans l'espace entre ces zones d'affichage 10 et 11 se trouve insérée une rampe linéaire composée de (seize) diodes émettrices de lumière ou électroluminescentes (DEL) 12 juxtaposées qui indiquent approximativement, par exemple, par le nombre de diodes adjacentes allumées, c'est-à-dire par la longueur du trait visible qu'elles constituent, la fréquence d'accord du circuit d'entrée (ou de l'amplificateur radio-fréquence) du récepteur. Ces diodes émettrices de lumière ne sont disponibles que dans certaines teintes, il est donc préférable de choisir la même teinte pour le colorant de la plaque 3 teintée pour ne pas trop atténuer la lumière émise par elles.

Dans l'un des coins supérieurs de la plaque 3 (ici du côté gauche), il est possible de représenter à l'aide d'un double afficheur de sept segments 13, des symboles d'identification de certaines stations émettrices de grande écoute ou de la gamme d'ondes reçues. Ces stations sont caractérisées par leurs fréquences d'émission respectives, on peut donc soit comparer de manière analogique la tension d'accord à une tension de référence propre à chaque station, soit d'utiliser l'indication numérique fournie par un synthétiseur de tension d'accord ou de fréquence (diviseur programmable) qui sera décrit plus loin, en comparant quelques-uns des digits les plus significatifs de celle-ci à ceux d'un nombre mémorisé correspondant à cette station ou en utilisant un décodeur/démultiplexeur. La plaque 3 peut être rendue solidaire du pourtour antérieur du boîtier 9 par collage, par exemple. Dans ce cas, la face avant de ce dernier qui porte les douilles de lampes d'éclairage et de signalisation, la rampe linéaire de diodes émettrices de lumière 12 et le double afficheur 13, est solidaire du châssis (non représenté) qui doit pouvoir être extrait par derrière. Les connexions électriques entre les zones métallisées de touches 5 à 8 et les circuits électroniques portés par le châssis peuvent alors être effectués à l'aide de contacts en forme de lames de ressorts.

La figure 3 est le schéma de principe simplifié du dispositif de commande entièrement électronique du récepteur « auto-radio », suivant l'invention.

Dans ce dispositif, chacune des touches sensibles (à effet de proximité) 5, 6, 7 et 8 est reliée à l'entrée de commande d'un oscillateur 15, 16, 17 et 18, dont le premier 15 est représenté de manière schématique.

Le récepteur comprend une borne d'alimentation positive 19 qui est réunie au pôle positif d'une batterie B dont le pôle négatif est relié au châssis métallique du véhicule, constituant la masse. Cette borne d'alimentation positive 19 est reliée au moyen d'une résistance 20 à l'entrée d'alimentation positive de l'oscillateur 15, cette dernière étant réunie à son entrée d'alimentation négative, reliée à la masse, au moyen d'un condensateur 21 formant avec la résistance 20 un circuit de découplage.

L'entrée d'alimentation positive de l'oscillateur 15 est réunie, en outre, au moyen d'un montage parallèle d'une résistance 150 et d'un condensateur 151, à l'émetteur d'un transistor bipolaire du type PNP 152 et au moyen d'une résistance 153 à la base de celui-ci. Cette base est réunie, en outre, au moyen d'une résistance 154 à l'entrée d'alimentation négative de l'oscillateur 15, à laquelle est également réuni le collecteur du transistor 152 par l'intermédiaire d'un circuit résonnant parallèle composé d'une inductance 155 et d'un condensateur 156. Cette inductance 155 est magnétiquement couplée, de manière serrée, à un enroulement de réaction 157 dont l'une des bornes est reliée à la base du transistor 152 et dont l'autre borne est reliée à l'entrée de commande 158 de l'oscillateur 15. Cette entrée de commande 158 est reliée à la zone métallisée de la face arrière de la plaque 3 qui constitue la touche 5 désignée par la lettre « A » (signifiant « arrêt »).

Les résistances 153 et 154 reliées en série entre les entrées d'alimentation positive et négative de l'oscillateur 15, polarisent la base du transistor PNP 152 de telle sorte qu'il soit conducteur en permanence.

La touche 5 étant bien isolée du reste du circuit, l'enroulement 157 ne fournit aucun courant à la base du transistor 152. Celui-ci n'entre en oscillation que lorsqu'une partie du corps de l'utilisateur, telle qu'une main ou un doigt, devient capacitivement couplée à la zone métallisée 5 en s'en approchant suffisamment. La réaction devient alors suffisante pour que l'oscillateur se mette à osciller et à fournir sur sa sortie 159 constituée par le collecteur du transistor 152, une onde de tension ayant une fréquence déterminée par les valeurs de l'inductance 155 et de la capacité 156 constituant le circuit collecteur résonnant de celui-ci. Cette fréquence est, par exemple, choisie dans la gamme des fréquences ultrasonores. Cette oscillation persiste jusqu'à ce que la partie du corps s'éloigne suffisamment de la touche 5.

La sortie 159 de l'oscillateur 15 est reliée à l'entrée d'un montage redresseur 25 comprenant une diode 250 dont l'anode constitue l'entrée et la cathode la sortie de ce montage 25. Cette cathode est, en outre, réunie à la masse au moyen d'un montage composé d'une résistance 251 et d'un condensateur 252 connectés en parallèle, dont la constante de temps (RC) est choisie supérieure au triple de la période de l'onde fournie par l'oscillateur 15. Le montage redresseur 25 fournit donc, en réponse à un train d'ondes de durée limitée correspondant à celle de l'activation de la touche 5, un signal rectangulaire positif sensiblement de même durée, dont les temps à la croissance et à la décroissance (ou de chute) sont déterminés par cette constante de temps.

La sortie du montage détecteur 25 est reliée à l'entrée d'un premier étage inverseur 22 en logique câblé, c'est-à-dire composé d'éléments discrets. Cette entrée est réunie au moyen d'une résistance série 220 à la base d'un transistor bipolaire du type NPN 221 dont l'émetteur est relié à la masse. Cette résistance 220 permet de limiter le courant de base de ce transistor 221 et, de ce fait, la charge connectée aux bornes du circuit résonnant LC 155-156 de l'oscillateur 15 pendant les demi-périodes positives de son oscillation. Il est parfois avantageux de connecter un condensateur 222 entre la base et l'émetteur du transistor 221, qui a pour effet d'augmenter encore les temps de montée et de chute des impulsions dont il retarde, en outre, les fronts avant et arrière. Le collecteur du transistor 221 qui constitue la sortie de cet étage inverseur 22, est réuni au moyen d'une résistance 223 à la sortie positive d'un régulateur de tension intégré 24 dont l'entrée positive est reliée à la borne d'alimentation positive 19 du récepteur. L'entrée et la sortie négatives de ce régulateur 24 sont toutes les deux reliées à la masse.

On notera ici que le régulateur de tension 24 dont l'entrée et la sortie positive sont, en outre, respectivement découplées à la masse au moyen de deux condensateurs 29 et 30, est destiné à alimenter l'ensemble du dispositif de commande électronique du récepteur à l'exception des oscillateurs 15 à 18, de l'interrupteur d'alimentation et de son étage de commande à transistors. Sa tension d'entrée étant celle de la batterie B (12 V), sa tension de sortie est choisie, notamment, en vue de l'alimentation des circuits intégrés logiques (par exemple, de 5 V) qui équipent le dispositif de commande. Afin qu'à l'état de veille la consommation de courant des circuits logiques (numériques) intégrés soit aussi réduite que possible, on choisit, de préférence, ceux du type généralement appelé « CMOS » ; cette abréviation d'origine américaine signifie qu'ils sont essentiellement composés de transistors à effet de champ de grille isolée (MOS), à symétrie complémentaire.

La sortie de l'étage inverseur 22, c'est-à-dire le collecteur du transistor NPN 221, est reliée à l'entrée d'horloge T d'un basculeur bistable de type « JK » 31 comprenant une entrée de remise à zéro R asynchrone et des entrées désignées par J et par K qui sont respectivement reliées (rebouclées) à sa sortie complémentaire $\bar{Q}$ et à sa sortie Q. Cette dernière est réunie, en outre, à la base d'un transistor bipolaire de type NPN 32 à travers une résistance de limitation du courant de base 33. L'émetteur de ce transistor 32 est relié à la masse et son collecteur est, d'une part, réuni à la borne d'alimentation positive 19 au moyen d'une résistance 34 et, d'autre part, relié à la base d'un autre transistor bipolaire du type NPN 35 dont le collecteur est également relié à cette borne 19 et dont l'émetteur est relié à la borne d'alimentation positive de sortie 36 qui alimente divers autres circuits du récepteur, ainsi que les lampes de signalisation et d'éclairage de celui-ci. L'interrupteur d'alimentation est donc constitué par le transistor 35 qui doit être capable de conduire à l'état saturé un courant d'intensité élevée et la résistance 34 qui est en même temps la résistance de polarisation de la base du transistor 35 et la résistance collecteur du transistor 32, forme avec ce dernier l'étage de commande de cet interrupteur.

Lorsque le basculeur « JK » 31 est à l'état haut (ou « un »), sa sortie Q fournit sensiblement la tension de sortie du régulateur 24 qui l'alimente, de sorte que le transistor de commande 32 est saturé et, par conséquent, le transistor interrupteur 35 est bloqué. Le récepteur est alors à l'arrêt et aucune des lampes devant éclairer sa façade 1 par l'arrière n'est allumée, celle-ci présentant alors un aspect opaque du fait que la plaque 3 est teintée.

Lorsque la main ou un doigt de l'utilisateur s'approche alors de la première zone sensible 5, l'oscillateur 15 se met à osciller et le redresseur 25 fournit un signal rectangulaire positif provoquant la saturation du transistor 221 de l'étage inverseur 22, dont le collecteur fournit alors à l'entrée d'horloge T du basculeur « JK » 31 un état bas (ou « zéro »). Grâce au rebouclage respectif des sorties Q et Q̄ aux entrées J et K, ces dernières ont respectivement reçu pendant l'état haut antérieurement appliqué à l'entrée T, un état bas et un état haut. La transition entre l'état haut et l'état bas à l'entrée T fait basculer le basculeur 31 dans son état bas ou zéro (apparaissant sur la sortie Q) qui provoque le blocage du transistor de commande 32 de sorte que le transistor interrupteur 35 polarisé sur sa base par la résistance 34 devient saturé et alimente le récepteur dont certaines lampes s'allument, notamment celles éclairant les touches sensibles 5 à 8.

Les autres touches sensibles 6, 7 et 8 sont également respectivement reliées aux entrées de commande d'autres oscillateurs associés 16, 17 et 18 semblables au premier 15, dont les sorties alimentent respectivement des montages redresseurs 26, 27 et 28 également semblables au premier 25.

Il est à remarquer ici que le dispositif de commande entièrement électronique peut être équipé d'autres types de circuits de commande activables par des touches à effet capacitif, connus, à condition qu'ils fournissent des signaux rectangulaires positifs de durée correspondant à celle de l'activation de la touche associée.

Selon un mode de réalisation perfectionné de l'invention, les sorties des autres montages redresseurs 26 à 28 sont respectivement reliées à trois entrées d'un circuit « OU » câblé 37 comprenant trois diodes 38, 39 et 40 dont les cathodes reliées ensemble forment la sortie. Cette sortie du circuit « OU » 37 est réunie à la base d'un transistor bipolaire de type PNP 41 au moyen d'une résistance 42. Cette base est, en outre, réunie à la masse au moyen d'une autre résistance 43. Le collecteur du transistor 41 est relié à la masse et son émetteur est, d'une part, relié à l'entrée de remise à zéro R du basculeur « JK » 31 et d'autre part, réuni à la sortie du régulateur de tension 24 au moyen d'une résistance 44. L'étage composé des éléments 42 à 44 constitue un étage séparateur, non-inverseur.

Lorsqu'aucune des autres touches sensibles 6, 7 et 8 n'est activée par la proximité d'une partie du corps de l'utilisateur, le transistor 41 est saturé du fait que sa base est réunie à son collecteur par l'intermédiaire de la résistance 43. L'entrée de remise à zéro R du basculeur 31 reçoit alors un état bas qui n'a pas d'effet sur son basculement par des signaux appliqués sur ses autres entrées T, J et K. Par contre, lorsqu'une ou plusieurs autres touches 6 à 8 sont activées, un ou plusieurs autres montages redresseurs 26 à 28 fournissent des signaux rectangulaires positifs qui rendent conductrices une ou plusieurs diodes 38 à 40 du circuit « OU » 37 de manière à faire passer un courant à travers les résistances 42 et 43 en série. Si l'amplitude de l'onde fournie par l'un ou moins des autres oscillateurs 16 à 18 est telle que celle du signal rectangulaire fourni par l'un des autres montages redresseurs 26 à 28 dépasse la tension régulée fournie par le régulateur 24 multipliée par l'inverse du rapport de division du diviseur de tension formé par les résistances 42 et 43 en série, le transistor 41 devient bloqué et l'entrée de remise à zéro R reçoit temporairement un état haut. Ceci constitue un signal rectangulaire appliqué à l'entrée R qui provoque la remise à l'état zéro du basculeur 31, s'il n'y était pas auparavant. Comme précédemment, l'état zéro sur la sortie Q provoque le blocage du transistor 32 et la saturation du transistor 35.

Cet agencement comprenant le circuit « OU » 37, les transistors 41 et les résistances 42 à 44, permet de commander la mise en route du récepteur par l'activation de n'importe quelle touche sensible 5 à 8 ou de plusieurs d'entre elles et de commander ensuite la fonction désirée (recherche d'une station, variation du volume, commutation de gamme) en activant la touche appropriée qui sont alors toutes rendues visibles grâce à l'éclairage par derrière.

Lorsque le basculeur « JK » 31 est à l'état zéro qui commande l'alimentation du récepteur par l'intermédiaire de la borne de sortie 36 du dispositif de commande de la figure 3, l'activation de la première touche sensible 5 désignée par le symbole « A » signifiant « arrêt », provoque sa remise à l'état haut. Pendant l'état zéro susmentionné, l'entrée J reliée à la sortie complémentaire Q̄ et l'entrée d'horloge T reliée à la jonction de la résistance 223 avec le collecteur du transistor 221 reçoivent respectivement des états hauts. L'activation de la touche « A » 5 provoque la mise en oscillation de l'oscillateur 15 et la fourniture à la sortie du montage redresseur 25 d'un signal rectangulaire positif qui commande la saturation du transistor 221. L'entrée d'horloge T est alors temporairement reliée à la masse et commande le basculement du basculeur 31 dans son état haut qui provoque à son tour la saturation du transistor de commande 32 et le blocage du transistor interrupteur 35. Les circuits du récepteur à l'exception du dispositif de commande ne sont plus alimentés alors et les lampes de signalisation et d'éclairage s'éteignent également de sorte que la façade 1 redevient d'aspect opaque.

La fonction de recherche automatique des stations émettrices est commandée par la seconde touche sensible 6 désignée par le symbole « R ». Son activation établit la réaction du second oscillateur 16 dont l'onde de sortie redressée par le second montage redresseur 26 constitue un signal rectangulaire positif. La sortie du second montage redresseur 26 est reliée à l'entrée d'un second inverseur 45 analogue au premier 22, qui comprend un transistor bipolaire du type NPN 450 dont la base est reliée au moyen d'une résistance de limitation de courant 451 à cette sortie, dont l'émetteur est relié à la masse et dont le collecteur est réuni au moyen d'une résistance collecteur 452 à la sortie du régulateur de tension 24.

Le collecteur du transistor 450 est relié, en outre, à une entrée de remise à un S̄ par un état bas, d'un premier basculeur bistable de verrouillage de type RS 46 (appelé « RS bistable latch » en anglais), composé de deux portes ET-NON 460 et 461 à deux entrées, couplées en « croix ». La sortie de la première porte ET-NON 460, est reliée à l'une des entrées de la seconde 461 dont l'autre entrée constitue celle de remise à zéro R̄ par un état bas. La sortie de la seconde porte 461 est reliée à celle des entrées de la première porte 460, qui n'est pas reliée au collecteur du transistor 450. Les sorties des deux portes ET-NON 460 et 461 constituent respectivement la sortie Q et la sortie complémentaire Q̄ du bistable 46.

Pendant l'état de veille du récepteur, où c'est uniquement le dispositif de commande électronique qui est alimenté, l'entrée S̄ reçoit un état haut à travers la résistance 452 et l'entrée R̄ reliée à un élément 47 (en pointillé) du récepteur, alimenté par la borne 36 qui est isolée par le transistor interrupteur 35 bloqué, reçoit un état bas. Par conséquent, le premier bistable RS 46 est à l'état zéro, c'est-à-dire que sa sortie Q fournit un état bas et sa sortie complémentaire Q̄, un état haut. Après la mise en route du récepteur par l'activation de l'une quelconque des touches 5 à 8, l'élément 47 alimenté par la borne 36 fournit également un état haut à l'entrée R̄, qui n'a pas d'effet sur l'état bistable RS 46.

L'activation de la seconde touche (« R ») 6 provoque, de la manière décrite précédemment en ce qui concerne la première 5, la saturation temporaire du transistor 450 qui applique ainsi un état bas à l'entrée S̄ du premier bistable RS 46 de sorte que la première porte 460 fournit dès lors un état haut faisant passer la sortie de la seconde porte 461 à l'état bas. Le premier bistable RS 46 est alors dans son état haut (Q = 1, Q̄ = 0).

On remarquera ici qu'il est également possible de réaliser un bistable de verrouillage RS au moyen de deux portes OU-NON couplées en croix, dont les basculements sont alors commandés par des états hauts. La sortie Q du premier bistable RS 46 est reliée à une des entrées d'une autre porte ET-NON 48 dont l'autre entrée est reliée à la sortie d'un premier multivibrateur astable 49 fournissant des signaux carrés ou rectangulaires (impulsions) d'une première fréquence prédéterminée.

Il est à remarquer ici que ce premier multivibrateur astable 49 est réalisé, de préférence, à l'aide de plusieurs portes ou inverseurs logiques intégrés du même type (« CMOS ») que les autres circuits numériques que comporte le dispositif de commande. Sur la figure 3, on l'a représenté comportant trois inverseurs connectés en anneau, réalisés à l'aide de trois portes NON-ET dont chacune a toutes ses entrées reliées en parallèle et dont l'un comporte un condensateur de contre-réaction reliant sa sortie à son entrée et qui en fait un étage intégrateur. L'intégrateur fournit une forme d'onde triangulaire qui appliquée à l'étage suivant utilise le seuil de commutation de celui-ci pour fournir des signaux rectangulaires récurrents, dont la fréquence dépend de la capacité du condensateur. Un multivibrateur astable à trois inverseurs en anneau, a été décrit dans l'article de FALDMAN paru à la page 59 de la revue américaine ELECTRONICS du 2 août 1971.

Lorsque l'une des entrées de la porte ET-NON 48 reçoit du basculeur 46 un état haut et son autre entrée reçoit du multivibrateur 49 un signal rectangulaire carré ou impulsionnel, elle fournit sur sa sortie reliée à l'entrée d'horloge H d'un premier compteur binaire 50, un signal complémentaire (en opposition de phase) par rapport à celui d'entrée. Le compteur 50 est du type dont chaque étage (basculeur « JK ») comporte une sortie parallèle (Qo ... Qn). Il peut être réalisé au moyen de plusieurs compteurs binaires à quatre bits connectés en cascade, c'est-à-dire que la sortie parallèle du dernier étage (Q3) du compteur précédent est reliée à l'entrée d'horloge du compteur suivant. Les entrées de remise à zéro asynchrone respectives de ces compteurs en cascade sont reliées en parallèle et, éventuellement, connectés à une source de signal de remise à zéro qui se produirait à chaque arrêt (ou démarrage) du récepteur ou à la masse (un compteur CMOS à 12 bits est du type 4040 par exemple).

Les sorties parallèles du compteur 50 sont respectivement reliées, éventuellement par l'intermédiaire d'étages séparateurs (« buffer » en anglais), aux entrées d'un convertisseur numérique-analogique 51, tel qu'un réseau de résistances dites « en échelle » ou « R-2R » (appelé « ladder network » en anglais), bien connu. La sortie du réseau convertisseur 51 fournit à la sortie 52 du dispositif de commande, éventuellement découplée à la masse au moyen d'un condensateur 53, une onde de tension en forme d'escalier qui varie d'un pas à chaque impulsion appliquée à l'entrée d'horloge H du compteur 50. La grandeur de ce pas dépend, d'une part, du nombre d'étages du compteur 50 et d'autre part, de la tension d'alimentation de celui-ci (ou de celle des étages séparateurs). Cette tension de sortie qui constitue la tension d'accord polarisant les diodes à capacité variable des circuits résonnants accordables du récepteur à l'envers, variera donc graduellement entre une faible valeur positive proche de zéro et sensiblement cette tension d'alimentation du compteur 50 ou du séparateur multiple s'il y a lieu. L'ensemble constitué par le multivibrateur 49, le compteur 50 et le réseau convertisseur 51, constitue un synthétiseur de tension simplifié qui forme le circuit de recherche automatique du récepteur.

On remarquera ici que les diodes à capacité variable doivent, notamment en ce qui concerne la réception des grandes ondes (de 150 à 300 kilohertz), former des capacités allant de quelques dizaines de picofarads à 500 pF environ (comme celle du type BB 212, par exemple), pour des tensions d'accord variant entre quelques centièmes et 10 volts.

L'arrêt de la recherche est commandé automatiquement par un signal rectangulaire (impulsion) négatif fourni par l'élément 47 du récepteur à l'entrée de remise à zéro par un état bas R̄ du premier bistable RS 46. Cet élément 47 est relié, d'une part, au circuit de commande automatique de gain (CAG) pour en recevoir une transition positive, lorsque l'oscillateur local fournit une fréquence qui permet de capter une porteuse d'émission modulée en amplitude (dans la gamme des grandes ondes) et d'autre part, au circuit de commande automatique de fréquence (CAF) qui fournit également une transition positive, lorsque l'oscillateur local a accroché une porteuse modulée en fréquence. Il comprend, en outre, un étage tel qu'un basculeur monostable, capable de fournir en réponse à cette transition positive, une impulsion négative dont le front avant est constitué par une transition entre un état haut et un état bas et dont le front arrière est une transition complémentaire à la précédente. Cette impulsion négative commande la remise à zéro du bistable RS 46 de telle sorte que la porte 48 dont une entrée est reliée à la sortie Q de ce dernier et dont l'autre entrée est reliée à la sortie du multivibrateur 49, fournit en permanence un état haut qui arrête le comptage du compteur 50 et, par conséquent, la recherche automatique. Par capter ou accrocher, on comprendra ici la réception d'une porteuse avec une amplitude suffisante pour faire fonctionner les circuits CAG ou CAF du récepteur.

Si le programme reçu alors ne correspond pas à celui désiré par l'auditeur, il suffit de réactiver la seconde touche sensible 6 (« R ») pour redémarrer la recherche automatique qui s'arrêtera de nouveau lorsqu'une porteuse de fréquence inférieure voisine est accrochée par le récepteur. Il est ainsi possible de parcourir la gamme de fréquences de haut en bas et de recommencer par le haut, lorsque le nombre d'impulsions comptées a dépassé d'une unité la capacité du compteur 50 (car il fournit alors des zéros sur toutes ses sorties parallèles).

Pour signaler des stations de grande écoute à l'aide d'un double afficheur de sept segments, certaines sorties parallèles du compteur 50 (ou d'un séparateur multiple alimenté par celles-ci) peuvent être reliées à des décodeurs composés de portes ET ou ET-NON qui sont combinées entre elles, de telle sorte que chacun d'eux fournit un état haut pour un mot binaire prédéterminé appliqué sur ses entrées et un état bas en réponse à tous les autres. Cet état haut peut commander un double générateur de caractères alphanumériques dont les sorties sont reliées de manière connue au double afficheur de sept segments. Chaque mot binaire correspondant à une fréquence porteuse d'une station émettrice, le double afficheur fournit le symbole lumineux de cette dernière à l'aide de deux lettres ou d'une lettre et d'un chiffre ou d'autres symboles prédéterminés, lorsque le compteur 50 s'arrête sur ce nombre.

Les deux autres touches sensibles 7 et 8 ont une double fonction d'une part, lorsque la recherche automatique est arrêtée, l'augmentation et la diminution du volume sonore et d'autre part, au cours de la recherche, la commutation des gammes de fréquence entre les grandes ondes (GO ou LW) ou les petites ondes (PO ou MW ou AM) et la modulation de fréquence (MF ou FM) ou la bande VHF (de 88 à 108 MHz).

Pour la commutation de gammes au cours de la recherche automatique, la sortie Q du premier bistable RS 46 est reliée à des premières entrées respectives de deux portes ET-NON 54 et 55 à deux entrées dont les secondes entrées sont respectivement reliées aux sorties du troisième 27 et du quatrième 28 montage redresseur. La sortie de la première 54 de ces deux portes 54, 55, est reliée à l'entrée de remise à un S̄ d'un second bistable de verrouillage RS 56 analogue au premier 46 (composé de deux portes ET-NON couplées en croix). La sortie de la seconde 55 de ces portes 54, 55 est reliée à l'entrée de remise à zéro R̄ du second bistable RS 56. La sortie Q de ce dernier est reliée à l'entrée de commande de la commutation de gammes 57 du récepteur, qui commande des commutateurs électroniques (à diodes, par exemple), agencés de façon classique.

Lorsque l'on active pendant l'état haut du premier bistable RS 46 la troisième touche sensible 7 désignée par le symbole « + », le troisième montage redresseur 27 qui lui est associé, fournit un signal rectangulaire positif, en réponse auquel la porte 57 fournit une impulsion négative qui correspond à l'application temporaire d'un état bas à l'entrée S̄.

Celle-ci commande la remise à « un » du second bistable RS 56 dont la sortie Q fournit un état haut commandant le commutateur de gammes pour que les circuits résonnants accordables du récepteur fonctionnent dans la bande VHF et pour que l'entrée de l'amplificateur basse (ou audio-) fréquence soit réunie au discriminateur ou démodulateur de fréquence.

Lorsque, dans les mêmes conditions, on active la quatrième touche sensible 8 désignée par le symbole « — », le quatrième montage redresseur 28 fournit un signal qui fait passer temporairement la sortie de la porte 55 reliée à l'entrée R̄ du second bistable RS 56, à l'état bas provoquant ainsi la remise à zéro de ce dernier. Sa sortie Q fournissant alors un état bas qui commande la commutation des circuits résonnants accordables pour qu'ils puissent recevoir des signaux dans la gamme des grandes ondes (GO) et de l'entrée de l'amplificateur basse fréquence pour qu'elle soit reliée au détecteur d'enveloppe ou démodulateur d'amplitude.

Lorsque la remise à zéro du premier bistable RS 46 provoque l'arrêt de la recherche en appliquant un état bas à l'une des entrées de la porte ET-NON 48, cet état bas est également appliqué aux premières entrées respectives des deux portes ET-NON 54 et 55 dont les sorties respectives fournissent alors des états hauts en permanence quel que soit le signal reçu par leurs secondes entrées. Le second bistable RS 56 est ainsi maintenu dans l'état qu'il avait antérieurement à la remise à zéro du premier 46 et il ne peut changer d'état qu'après la reprise de la recherche automatique.

L'état zéro du premier bistable RS 46 autorise, par contre, la commande du volume sonore par l'activation de l'une ou l'autre des touches sensibles 7 (« + ») et 8 (« — »). A cette fin, la sortie complémentaire Q̄ qui fournit alors un état haut, est reliée ici à l'une des entrées d'une porte ET-NON à trois entrées 58 dont les deux autres entrées sont respectivement reliées aux sorties de deux autres portes ET-NON à deux entrées 59 et 60 chacune. Les premières entrées des portes 59 et 60 sont respectivement reliées aux sorties du troisième 27 et du quatrième 28 montages redresseurs qui sont respectivement associés aux touches « + », 7 et « — », 8. Les secondes entrées respectives des portes 59 et 60 sont reliées en parallèle à la sortie d'un étage intégrateur comprenant un étage inverseur logique intégré réalisé au moyen d'une porte ET-NON 61 dont toutes les entrées sont reliées en parallèle, et un condensateur de contre-réaction 62 réunissant la sortie de l'inverseur 61 à son entrée. L'entrée de l'étage intégrateur (61, 62) est reliée à la sortie de la porte 58. L'ensemble ainsi constitué forme un second multivibrateur astable 63 avec une fonction d'aiguillage sélectif sur deux sorties 64 et 65, qui est commandé par les deux dernières touches sensibles 7 et 8.

Plus précisément, lorsque le premier bistable RS 46 est à l'état zéro et sa sortie complémentaire Q̄ applique un état haut à l'une des trois entrées de la porte 58 qui reçoit, en dehors des intervalles d'activation de l'une des touches 7 et 8, également des états hauts sur ses autres entrées, la sortie de cette porte 58 fournit un zéro à l'entrée de l'inverseur 61. La sortie de l'inverseur 61 reliée à l'une des armatures du condensateur 62 dont l'autre armature est alors à la masse, assure la charge graduelle de celui-ci à partir de l'instant où la porte 58 commence à fournir un état bas, jusqu'à ce que cette sortie atteigne un état haut. Cette tension croissante est appliquée en parallèle aux secondes entrées respectives des deux portes 59 et 60 jusqu'au dépassement d'un seuil de commutation. A partir de ce seuil, lorsque l'activation de la touche « + » 7 fait appliquer un état haut à la première entrée de la porte 59 ou celle de la touche « — » 8 fait de même en ce qui concerne la porte 60, elles deviennent capables de fournir un état bas. Cette activation de l'une des touches 7, 8 établit donc une voie de réaction en faisant appliquer un état bas provenant des sorties de l'une des portes 59, 60, à l'une des entrées de la porte 58 dont la sortie passe alors à l'état haut qui a pour effet de décharger le condensateur 62 de telle sorte que la sortie de l'inverseur 61 fournit dès lors une tension graduellement décroissante. Celle-ci est appliquée en parallèle aux secondes entrées de portes 59, 60 dont l'une (59 ou 60) reçoit sur sa première entrée un état haut de l'un des montages redresseurs 27, 28. Dès que la tension décroissante est devenue inférieure à un seuil de commutation (inférieur au précédent à cause de l'hystérésis), la sortie de cette porte (59 ou 60) fournit un état haut qui fait passer celle de la porte 58 à l'état bas qui à son tour provoque la recharge du condensateur 62.

On obtient ainsi que, pendant l'intervalle de l'activation de l'une des touches 7 ou 8, le multivibrateur monostable 63 fonctionne et fournit sur l'une de ses sorties 64 et 65 respectivement reliées à celles des portes 59 et 60, des signaux périodiques, sensiblement de forme carrée. La sortie 64 est donc associée à la touche « + », 7 et la sortie 65 à la touche « — », 8, après que le dispositif de recherche automatique (49-50-51) ait été arrêté sur une tension d'accord correspondant à une station émettrice, par la remise à zéro du premier bistable RS 46.

On remarquera ici que le circuit 63 peut être réalisé au moyen d'un multivibrateur astable à trois inverseurs logiques en anneau (voir élément 49) dont l'un des inverseurs serait remplacé par une porte ET-NON à deux entrées dont l'une est connectée à la sortie de l'inverseur en amont et dont l'autre serait reliée à la sortie complémentaire Q̄ du premier bistable RS 46. Ce multivibrateur fonctionnerait alors pendant chaque arrêt du dispositif de recherche sur une station émettrice. L'aiguillage peut alors être assuré par deux autres portes NON-ET dont les premières entrées seraient reliées en parallèle à la sortie de ce multivibrateur astable et dont les secondes entrées seraient respectivement reliées au troisième 27 et au quatrième 28 montage redresseur. Un tel montage comporterait un élément inverseur ou porte en plus.

Les sorties 64 et 65 du circuit 63 sont respectivement reliées aux entrées de comptage U et de décomptage D d'un compteur-décompteur binaire synchrone 66 à deux entrées d'horloge (U et D), qui comprend, en outre, autant d'entrées de données asynchrones (non représentées) et de sorties parallèles (Qo ... Qn) que d'étages (basculeurs JK), ainsi que des entrées respectives de prépositionnement L (« load input » en anglais) et de remise à zéro R à des sorties respectives de retenue B (« borrow » en anglais) et de report C (« carry » en anglais). Les entrées de données sont reliées ici à la masse et les entrées de prépositionnement L et de remise à zéro R sont reliées ensemble à la sortie de retenue B.

Les sorties parallèles du compteur-décompteur 66 sont reliées aux entrées parallèles d'un second réseau convertisseur en échelle « R-2R » 67 (du même type que le premier 51) dont la sortie reliée à l'entrée de commande du volume sonore 68 (éventuellement découplée au moyen d'un condensateur 69), fournit une tension en marches d'escalier, croissante lorsque les signaux carrés sont fournis à l'entrée de comptage U (« up » en anglais) ou décroissante lorsque c'est l'entrée de décomptage D (« down » en anglais) qui les reçoit.

En utilisant un compteur-décompteur binaire à quatre étages, chaque incrément (ou décrément) de tension est sensiblement égal à un seizième de la tension d'alimentation de celui-ci. Il est possible de mettre en cascade plusieurs de ces compteurs-décompteurs de manière classique pour réduire l'incrément. Il faut alors augmenter la fréquence du second multivibrateur astable 63 en réduisant la capacité du condensateur 62.

La tension fournie par la sortie du réseau convertisseur 67 à l'entrée de commande de volume 68, doit être appliquée à l'entrée de commande d'un élément dont le gain est commandable par une tension. Un tel élément (non représenté) peut être constitué par montage potentiométrique (diviseur de tension résistif à facteur de division variable) comprenant une ou plusieurs résistances dont la valeur varie en fonction d'une tension continue. Une telle résistance variable peut être constituée par un ou plusieurs transistors à cet effet de champ à grille isolée (IGFET ou MOSFET).

Il est à noter ici que, pour faciliter l'utilisation des touches 7 et 8 à double fonction, les deux fonctions de chacune d'elles peuvent être indiquées par deux symboles ou abréviations en transparence, respectivement disposés dans deux quadrants diagonalement opposés de la touche et éclairés par deux lampes distinctes, respectivement commandées par des signaux présents sur les sorties Q et Q̄ du premier bistable RS 46. Ainsi, il est possible de rajouter l'abréviation MF (modulation de fréquence) dans le coin inférieur gauche de la touche 7 et l'abréviation GO (grandes ondes) dans celui de la touche 8. Pendant le déroulement de la recherche automatique, c'est les lampes éclairant respectivement les symboles FM et GO qui sont allumées et lors de l'arrêt de cette recherche, c'est celles éclairant les symboles « + » et « — » qui s'allument pour permettre à l'utilisateur de constater qu'il reçoit une station émettrice même lorsque le son est absent (volume réglé au minimum).

L'indicateur d'accord est constitué par la rampe à diodes émettrices de lumière (12 de la figure 2) qui en comporte seize en alignement. Ces diodes sont respectivement reliées à seize sorties d'un décodeur/démultiplexeur (non représenté) de quatre voies vers seize (tel que celui du type 54154 ou 74154 en TTL). Les quatre entrées de ce décodeur sont respectivement reliées aux quatre sorties parallèles du compteur 50 qui fournissent les quatre digits les plus significatifs du mot de sortie de celui-ci.

Dans l'un des modes de réalisation du récepteur, le double afficheur sept segments (13 de la figure 2) est également commandé à partir des mots fournis par ces quatre sorties parallèles fournissant les digits les plus significatifs, qui sont soit décodés, soit comparés à des mots mémorisés à quatre bits correspondant à des fréquences proches de celles des stations à grande écoute dans la gamme des grandes ondes. Lorsqu'un décodeur/démultiplexeur fournit un état actif sur l'une des sorties choisies et la sortie Q du second bistable RS 56 indique que l'on reçoit la gamme des grandes ondes (par un zéro), deux générateurs de caractères alphanumériques préalablement choisis sont rendus actifs de façon à afficher deux symboles lumineux. Si aucune de ces sorties n'est active, un double générateur de caractères fait afficher le symbole « GO ». Pour la modulation de fréquence, un autre double générateur de caractères commandé par l'état haut à la sortie Q du second bistable RS 56 fait afficher le symbole « MF » ou « UW » ou « FM ». L'état de sortie de ce bistable 56 commande également l'éclairage alterné de zones 10 et 11 de la figure 1.

L'invention n'est nullement limitée aux modes de réalisation décrits ci-dessus, mais elle en englobe tous les équivalents techniques pouvant remplir les mêmes fonctions à l'aide d'autres moyens connus en soi. Il est, par exemple, possible de remplacer le second bistable « RS » 56 commandant la commutation de gammes par un basculeur JK rebouclé en croix et commandé sur son entrée d'horloge T par l'intermédiaire d'une touche supplémentaire. Les transistors bipolaires peuvent être, d'autre part, remplacés par des transistors à effet de champ et certaines portes ET-NON par des portes ET. Il est également possible de modifier le circuit multivibrateur-aiguilleur combiné 63 en mettant à la place des deux portes à deux entrées 59 et 60, deux portes à trois entrées dont chacune aurait son entrée supplémentaire reliée à la sortie complémentaire Q̄ du premier bistable « RS » 46 et en remplaçant la première porte à trois entrées 58 par une à deux entrées qui seraient respectivement reliées aux sorties 64 et 65 et la seconde porte à trois entrées 61 par un inverseur ou une autre porte à deux entrées reliées en parallèle.

**Revendications**

1. Récepteur de radiophonie destiné à être monté à poste fixe, à bord d'un véhicule automobile, dont les circuits sont contenus à l'intérieur d'un boîtier fermé (9) comprenant une face avant ou façade (1) pouvant rester seule accessible à l'utilisateur en vue de commander diverses fonctions du récepteur, telles que sa mise en route, son arrêt, la recherche automatique de stations émettrices, la commutation de gammes de fréquences et/ou du type de modulation de l'onde porteuse reçue et l'intensité du volume sonore, caractérisé en ce que la façade comporte une plaque transparente teintée (3) avec des zones sensibles (5, 6, 7, 8) pour commander toutes les fonctions du récepteur et des zones (10, 11, 13) pour afficher les informations telle que la fréquence d'une station reçue, et en ce que le récepteur comporte des moyens émetteurs de lumière à l'arrière de la façade, c'est-à-dire à l'intérieur du boîtier (9), pour afficher les zones de commande et les zones d'affichage lorsque le récepteur est en fonctionnement, ladite plaque frontale teintée étant telle qu'elle reste opaque, lesdites zones étant pratiquement invisibles, lorsque les moyens émetteurs de lumière ne fonctionnent pas.

2. Récepteur selon la revendication 1, caractérisé en ce qu'il comprend un dispositif de commande tel que la mise sous tension du récepteur résulte de l'actionnement de n'importe quelle zone de commande sur la façade.

3. Récepteur selon la revendication 1 ou 2, caractérisé en ce que la façade est en une matière plastique isolante.

4. Récepteur selon la revendication 3, caractérisé en ce que la matière plastique isolante est constituée par une résine acrylique mélangée à un colorant.

5. Récepteur selon l'une quelconque des revendications précédentes, caractérisé en ce que chaque zone de commande comprend, sur la face arrière de ladite plaque frontale, une partie qui est plus transparente que le reste de cette zone de sorte que cette partie à plus grande transparence apparaisse plus claire que son environnement quand les moyens émetteurs de lumière sont en fonctionnement, cette partie étant un symbole représentant la fonction de cette zone de commande.

6. Récepteur selon la revendication 5, caractérisé en ce que la partie la moins transparente de la zone de commande est recouverte, sur ladite face arrière de la plaque de façade, d'une couche métallique.

7. Récepteur selon la revendication 6, caractérisé en ce que la couche métallique forme une électrode d'un condensateur, la zone de commande fonctionnant comme une touche à effet de proximité capacitif coopérant avec une partie, telle qu'un doigt, du corps de l'utilisateur.

8. Récepteur selon l'une quelconque des revendications précédentes, caractérisé en ce qu'il comprend un nombre d'oscillateurs égal au nombre de zones de commande, chacun de ces oscillateurs émettant un signal quand une partie du corps de l'utilisateur est au voisinage de la zone de commande correspondante, cet oscillateur fournissant un signal de commande à l'électrode de commande d'un interrupteur afin de connecter le récepteur à une source et d'exciter les moyens émetteurs de lumière.

9. Récepteur selon l'une quelconque des revendications précédentes, caractérisé en ce qu'il comprend derrière lesdites zones d'affichage, une ligne de diodes émettrices de lumière (LED) et des moyens de commande tels que le nombre de diodes émettrices de lumière qui est excité est fonction de la fréquence d'accord, la couleur de ladite plaque frontale étant telle que cette plaque est transparente à la lumière émise par lesdites diodes.

10. Récepteur suivant la revendication 7, caractérisé en ce que le circuit de commande (15-25) associé à la première touche (5) est couplé à celle (T) des entrées de commande d'un basculeur bistable de type JK (31) commandant un interrupteur électronique (35) d'alimentation, qui provoque son basculement d'un état quelconque dans un état complémentaire en réponse à chaque signal rectangulaire qu'il fournit, afin que cette première touche (5) puisse commander indifféremment l'arrêt et la mise en route du récepteur, et en ce que les signaux rectangulaires provenant des autres circuits de commande (16-26, 17-27, 18-28) respectivement associés aux autres touches (6, 7, 8) sont appliqués, combinés au moyen d'une porte « OU » (37), à celle (R) des entrées de commande du basculeur JK (31) qui provoque sa mise dans un état commandant la fermeture de l'interrupteur (35).

11. Récepteur suivant la revendication 6, caractérisé en ce que, lorsque le récepteur est en état de fonctionnement, le signal rectangulaire engendré par l'activation d'une touche (6) commande le démarrage de la recherche automatique de stations qui est effectuée de manière connue en soi, en provoquant le basculement d'un premier basculeur bistable de type RS (46) dans un premier état pendant la durée duquel, la commande de la commutation des gammes de fréquence par l'intermédiaire respectif des signaux rectangulaires engendrés par l'activation de la troisième (7) et de la quatrième (8) touche, est autorisée et la commande respective de l'accroissement et de la diminution du volume sonore par ces mêmes touches (7, 8) est inhibée, et en ce que le basculement du premier basculeur RS (46) dans un second état, qui est commandé par un signal en provenance d'un circuit de démodulation (47) du récepteur, indiquant la réception d'une onde porteuse d'amplitude suffisante, provoque l'arrêt de la recherche automatique, l'inhibition de la commutation de gammes et l'autorisation de la commande du volume sonore par l'activation de la troisième (7) ou de la quatrième (8) touche.

12. Récepteur suivant la revendication 11, caractérisé en ce que le premier basculeur RS (46) commande une première porte de coïncidence du type ET ou NON-ET (48), insérée entre une horloge ou premier multivibrateur astable (49) et l'entrée série (H) d'un premier compteur binaire (50) dont les sorties parallèles alimentant un premier convertisseur numérique-analogique (51) fournissant la tension d'accord destinée à polariser à l'envers les diodes à capacité variable des circuits d'accord du récepteur, qui croît par incréments récurrents égaux pendant la recherche automatique, une seconde porte de coïncidence (54) insérée entre le circuit de commande (17-27) associé à la troisième touche (7) et celle (S̄) des entrées de commande (S̄, R̄) d'un second basculeur RS (56) qui commande le basculement de celui-ci dans un premier état correspondant à l'une des gammes de fréquences, une troisième porte de coïncidence (55) insérée entre le circuit de commande (18-28) associé à la quatrième touche (8) et l'autre entrée de commande (R̄) du second basculeur RS (56) qui commande son basculement dans un second état correspondant à l'autre gamme de fréquences, ces trois portes (48, 54, 55) étant passantes pendant le premier état du premier basculeur RS (46) et bloquées pendant le second, et une quatrième porte de coïncidence (58) autorisant l'oscillation d'un second multivibrateur astable (63) pendant le second état du premier basculeur RS (46) et l'inhibant pendant le premier.

13. Récepteur suivant la revendication 12, caractérisé en ce que la commande du volume sonore est effectuée durant le second état du premier basculeur (46), de manière connue en soi, au moyen d'un compteur-décompteur (66) dont les sorties parallèles alimentent un second convertisseur numérique-analogique (67) fournissant une tension de commande à un élément à gain variable en fonction de celle-ci, inséré dans la voie d'amplification audio-fréquence du récepteur, et en ce que le second multivibrateur (63) alimente par l'intermédiaire d'un dispositif d'aiguillage (59, 60), l'entrée de comptage (U) du compteur-décompteur (66), pendant l'activation de la troisième touche (7), et l'entrée de décomptage (D) de celui-ci, pendant l'activation de la quatrième touche (8).

14. Récepteur suivant la revendication 13, caractérisé en ce que le dispositif d'aiguillage (59, 60) comporte deux portes de coïncidence (59, 60) à deux entrées, respectivement commandées sur leurs premières entrées par les signaux rectangulaires obtenues par l'activation de la troisième (7) et de la quatrième (8) touche, qui sont respectivement reliées par leurs premières entrées à la sortie d'un étage intégrateur (61, 62) formé par un inverseur logique (61) et un condensateur (62) réunissant la sortie de celui-ci à son entrée, et dont les sorties (64, 65) sont respectivement reliées, outre les entrées de comptage (U) et de décomptage (D), à deux entrées d'une autre porte de coïncidence (58) dont la sortie est reliée à l'entrée de l'intégrateur (61, 62), de façon à former deux boucles de réaction qui se referment respectivement par l'activation de la troisième (7) et de la quatrième (8) touche, lorsque toutes ces portes (59, 60, 58) sont du type NON-ET.

15. Récepteur suivant la revendication 14, caractérisé en ce que cette autre porte de coïncidence (58) comporte trois entrées dont l'une est reliée à l'une des sorties (Q̄) du premier basculeur RS (46) afin que, lorsque ce dernier est dans son second état, elle soit passante pendant la durée d'activation de l'une des troisième (7) et quatrième (8) touches, et qu'elle soit bloquée durant son premier état.

16. Récepteur suivant l'une quelconque des revendications 12 à 15, caractérisé en ce que celles des sorties parallèles du premier compteur binaire (50) qui fournissent les quatre digits les plus significatifs sont, en outre, respectivement reliées à un décodeur/démultiplexeur à quatre entrées et seize sorties qui sont respectivement reliées à seize diodes émettrices de lumière formant une rampe (12) d'indication de l'accord.

17. Récepteur suivant l'une quelconque des revendications 12 à 16, caractérisé en ce que celles des sorties parallèles du premier compteur binaire (50) qui fournissent les quatre digits les plus significatifs sont, en outre, reliées à un ou plusieurs autres décodeurs dont diverses sorties commandent chacune deux générateurs de caractères alphanumériques qui commandent respectivement deux afficheurs de sept segments (13) juxtaposés pouvant indiquer la gamme de fréquences ou la réception de stations de grande écoute dans la gamme des grandes ou des petites ondes, à l'aide de symboles, lettres ou chiffres prédéterminés.

18. Récepteur suivant l'une quelconque des revendications 12 à 16, caractérisé en ce que, lorsque le second bistable RS (56) indique la réception d'ondes modulées en fréquence dans la bande VHF, le double afficheur (13) est commandé au moyen d'un autre double générateur de caractère de façon à afficher d'autres symboles (FM, MF, UW).

## Claims

1. Radio receiver adapted to be mounted at a fixed location in an automobile, the circuits thereof are contained inside a closed housing (9) comprising a front face or front plate (1) which is the only one that can remain accessible for a user to control various functions of the receiver such as its switching on, switching off, the automatic transmitter station searching, the switching of the frequency bands and/or of the modulation type of the received carrier wave and the intensity of sound volume, characterized in that the front face comprises a colored transparent plate (3) with sensitive zones (5, 6, 7, 8) to control all of the functions of the receiver and zones (10, 11, 13) for displaying information such as the frequency of a received station, and in that the receiver comprises light emitting means behind the front plate, i. e. inside of the housing (9), for displaying the control zones and the display zones when the receiver is operating, said colored front plate being such that it remains opaque, said zones being practically invisible, when the light emitting means are inoperative.

2. Receiver according to claim 1, characterized in that it comprises a control device such that the application of voltage to the receiver results from the activation of any control zone on the front plate.

3. Receiver according to claims 1 or 2, characterized in that the front plate is made of an insulating plastics material.

4. Receiver according to claim 3, characterized in that the insulating plastics material is made up by an acrylic resin mixed with a dye.

5. Receiver according to any of the preceding claims, characterized in that each control zone comprises on the rear face of said front plate a portion which is more transparent than the remainder of this zone, so that this portion with increased transparency appears brighter than its surroundings when the light emitting means are operating, this portion being a symbol representing the function of this control zone.

6. Receiver according to claim 5, characterized in that the least transparent portion of the control zone is covered with a metallic layer on said rear face of the front plate.

7. Receiver according to claim 6, characterized in that the metallic layer forms an electrode of a capacitor, the control zone operating as a key of the capacitive proximity effect type cooperating with a member such as a finger of the body of the user.

8. Receiver according to any of the preceding claims, characterized in that it comprises a number of oscillators equal to the number of control zones, each of these oscillators emitting a signal when a member of the body of the user is in the neighborhood of the corresponding control zone, this oscillator supplying a control signal to the control electrode of an interrupter in order to connect the receiver to a source and to excite the light emitting means.

9. Receiver according to any of the preceding claims, characterized in that it comprises behind said display zones a line of light emitting diodes (LED) and control means such that the number of excited light emitting diodes is a function of the tuning frequency, the color of said front plate being such that this plate is transparent to the light emitted by said diodes.

10. Receiver according to claim 7, characterized in that the control circuit (15-25) associated with the first key (5) is coupled to that (T) of the control inputs of a bistable latch (31) of the JK type controlling an electronic supply interrupter (35), which controls the switching thereof from an arbitrary state into a complementary state in response to each rectangular signal which it supplies so that this first key (5) can arbitrarily control the switching off and switching on of the receiver, and in that the rectangular signals originating from the other control circuits (16-26, 17-27) respectively associated with the other keys (6, 7, 8) are applied, as combined by means of an OR gate (37), to that (R) of the control inputs of the JK latch (31) which causes its switching into a state controlling the closing of the interrupter (35).

11. Receiver according to claim 6, characterized in that, when the receiver is in its operating state, the rectangular signal generated by the activation of a key (6) controls the starting of the automatic station searching which is performed in a manner known *per se* by causing the switching of a first bistable latch of RS type (46) into a first state for the duration of which the control of the switching of the frequency bands by means of the respective rectangular signals generated by the activation of the third (7) and fourth (8) keys is enabled and the respective control of a sound volume increase or decrease by these same keys (7, 8) is inhibited, and in that the switching of the first RS latch (46) into a second state, which is controlled by a signal originating from a demodulation circuit (47) of the receiver indicating the reception of a carrier wave with sufficient amplitude, causes the stopping of the automatic searching, the inhibition of the band switching and the authorization of the sound volume control by activation of the third (7) or the fourth (8) key.

12. Receiver according to claim 11, characterized in that the first RS latch (46) controls a first coincidence gate of AND or NAND type (48) inserted between a clock or first astable multivibrator (49) and the serial input (H) of a first binary counter (50) the parallel outputs of which feed a first digital-analog converter (51) supplying the tuning voltage for the reverse polarization of the variable capacity diodes of the tuning circuits of the receiver, which increases by recurrent equal increments during the automatic searching, a second coincidence gate (54) inserted between the control circuit (17-27) associated with the third key (7) and that (S̄) of the control inputs (S̄, R̄) of a second RS latch (56) which controls the switching thereof into a first state corresponding to one of the frequency bands, a third coincidence gate (55) inserted between the control circuit (18-28) associated with the fourth key (8) and the other control input (R̄) of the second RS latch (56) which controls its switching into a second state corresponding to the other frequency band, these three gates (48, 54, 55) being conductive during the first state of the first RS switch (46) and blocked during the second, and a fourth coincidence gate (58) enabling the oscillation of a second astable multivibrator (63) during the second state of the first RS latch (46) and inhibiting it during the first.

13. Receiver according to claim 12, characterized in that the control of the sound volume is performed during the second state of the first latch (46), in a manner known *per se*, by means of an up/down counter (66) the parallel outputs of which feed a second digital-analog converter (67) supplying a control voltage to an element having a gain which is variable is function thereof, and inserted into the audiofrequency amplification path of the receiver, and in that the second multivibrator (63) feeds through a changeover device (59, 60) the up counting input (U) of the up/down counter (66) during the activation of the third key (7) and the downward counting input (D) thereof during activation of the fourth key (8).

14. Receiver according to claim 13, characterized in that the changeover device (59, 60) comprises two coincidence gates (59, 60) having two inputs respectively controlled on their first inputs by the rectangular signals obtained by activation of the third (7) or fourth (8) key, which are respectively connected at their first inputs to the output of an integrating stage (61, 62) formed by a logic inverter (61) and a capacitor (62) connecting its output to its input, and the outputs (64, 65) of which are respectively connected, in addition to the up (U) and down (D) counting inputs, to both inputs of a further coincidence gate (58) the output of which is connected to the input of the integrator (61, 62), in a manner to form two feedback loops which are respectively closed by activation of the third (7) and fourth (8) key, if all of these gates (59, 60, 58) are of NAND type.

15. Receiver according to claim 14, characterized in that this further coincidence gate (58) comprises three inputs one of which is connected to one of the outputs ($\bar{Q}$) of the first RS latch (46) so that when the latter is in its second state it is conductive during the activation of one of the third (7) and fourth (8) keys, and is blocked during its first state.

16. Receiver according to any of claims 12 to 15, characterized in that those of the parallel outputs of the first binary counter (50) which supply the four most significant digits are further respectively connected to a decoder/demultiplexer having four inputs and sixteen outputs which are respectively connected to sixteen light emitting diodes forming a tuning indication ramp (12).

17. Receiver according to any of claims 12 to 16, characterized in that those of the parallel outputs of the first binary counter (50) which supply the four most significant digits are further connected to one or a plurality of further decoders various outputs of which control each of two alphanumeric character generators respectively controlling two adjacent seven segment displays (13) adapted to display the frequency band or the reception of long range stations in the long or short wave bands by means of predetermined symbols, letters or numbers.

18. Receiver according to any of claims 12 to 16, characterized in that, when the second RS latch (56) indicates the reception of frequency modulated waves in the VHF range, the double display (13) is controlled by means of a further double character generator in a manner to display further symbols (FM, MF, UW).

**Patentansprüche**

1. Rundfunkempfänger, der dazu bestimmt ist, an fester Stelle in einem Kraftfahrzeug eingebaut zu werden, mit Schaltkreisen, die im Inneren eines geschlossenen Gehäuses (9) enthalten sind, das eine Vorderfläche oder Frontplatte (1) umfaßt, welche allein für den Benutzer zugänglich bleibt, um verschiedene Funktionen des Empfängers zu steuern, wie sein Einschalten, sein Ausschalten, den automatischen Sendersuchlauf, die Umschaltung der Frequenzbereiche und/oder der Modulationsart der empfangenen Welle und die Lautstärke, dadurch gekennzeichnet, daß die Frontplatte eine gefärbte lichtdurchlässige Platte (3) mit empfindlichen Zonen (5, 6, 7, 8) zur Steuerung aller Funktionen des Empfängers und Zonen (10, 11, 13) zum Anzeigen der Informationen wie die Frequenz einer empfangenen Station umfaßt, und daß der Empfänger Lichtaussendemittel auf der Rückseite der Frontplatte, d. h. im Inneren des Gehäuses (9), enthält, um die Steuerzonen und die Anzeigezonen anzuzeigen, wenn der Empfänger in Betrieb ist, wobei die genannte gefärbte Frontplatte derart ausgebildet ist, daß sie undurchsichtig ist und die genannten Zonen praktisch unsichtbar sind, wenn die Lichtaussendemittel nicht in Betrieb sind.

2. Empfänger nach Anspruch 1, dadurch gekennzeichnet, daß er eine Steuervorrichtung umfaßt, die derart ist, daß ein Unterspannungsetzen des Empfängers aus der Betätigung einer beliebigen Steuerzone auf der Frontplatte resultiert.

3. Empfänger nach Anspruch 1 oder 2, dadurch gekennzeichnet, daß die Frontplatte aus einem isolierenden Kunststoffmaterial besteht.

4. Empfänger nach Anspruch 3, dadurch gekennzeichnet, daß das isolierende Kunststoffmaterial durch ein mit einem Farbstoff vermischtes Acrylharz gebildet ist.

5. Empfänger nach einem der vorstehenden Ansprüche, dadurch gekennzeichnet, daß jede Steuerzone auf der Rückseite der genannten Frontplatte einen Teil aufweist, der stärker lichtdurchlässig als der übrige Teil dieser Zone ist, so daß dieser Teil mit größerer Lichtdurchlässigkeit heller erscheint als seine Umgebung, wenn die Lichtaussendemittel in Betrieb sind, wobei dieser Teil ein Symbol ist, welches die Funktion dieser Steuerzone darstellt.

6. Empfänger nach Anspruch 5, dadurch gekennzeichnet, daß der am wenigsten lichtdurchlässige Teil der Steuerzone auf der genannten Rückseite der Frontplatte mit einer Metallschicht bedeckt ist.

7. Empfänger nach Anspruch 6, dadurch gekennzeichnet, daß die Metallschicht eine Kondensatorelektrode bildet, wobei die Steuerzone als Taste mit kapazitivem Näherungseffekt wirkt, welche mit einem Körperteil des Benutzers wie ein Finger zusammenwirkt.

8. Empfänger nach einem der vorstehenden Ansprüche, dadurch gekennzeichnet, daß er eine Anzahl von Oszillatoren umfaßt, die gleich der Anzahl von Steuerzonen ist, wobei jeder dieser Oszillatoren ein Signal abgibt, wenn ein Körperteil des Benutzers sich in der Nähe der entsprechenden Steuerzone befindet, wobei dieser Oszillator ein Steuersignal an die Steuerelektrode eines Unterbrechers abgibt, um den Empfänger mit einer Quelle zu verbinden und die Lichtaussendemittel zu erregen.

9. Empfänger nach einem der vorstehenden Ansprüche, dadurch gekennzeichnet, daß er hinter den genannten Anzeigezonen eine Leuchtdiodenzeile (LED) und Steuermittel umfaßt, dergestalt, daß die Anzahl von Leuchtdioden, die erregt werden, von der Abstimmfrequenz abhängt, wobei die Farbe der genannten Frontplatte derart ist, daß diese Platte durchlässig für das von den genannten Dioden ausgesandte Licht ist.

10. Empfänger nach Anspruch 7, dadurch gekennzeichnet, daß die Steuerschaltung (15-25), welche der ersten Taste (5) zugeordnet ist, an denjenigen (T) der Steuereingänge einer bistabilen, einen elektronischen Versorgungsunterbrecher (35) steuernden Kippschaltung (31) vom JK-Typ angekoppelt ist, der ihr Kippen von einem beliebigen Zustand in einen komplementären Zustand ansprechend auf jedes von ihr gelieferte Rechtecksignal verursacht, damit diese erste Taste (5) beliebig das Ausschalten und das Einschalten des Empfängers steuern kann, und daß die Rechtecksignale, welche von den anderen Steuerschaltungen (16-26, 17-27, 18-28) herrühren, die jeweils den anderen Tasten (6, 7, 8) zugeordnet sind, mittels einer OR-Torschaltung (37) kombiniert an denjenigen (R) der Steuereingänge der JK-Kippschaltung (31) angelegt werden, der ihre Einstellung in einen Zustand verursacht, welcher das Schließen des Unterbrechers (35) steuert.

11. Empfänger nach Anspruch 6, dadurch gekennzeichnet, daß im Betriebszustand des Empfängers das Rechtecksignal, welches durch Aktivierung einer Taste (6) erzeugt wird, das Anlaufen des automatischen Sendersuchlaufs steuert, der in an sich bekannter Weise abläuft, indem das Kippen einer ersten bistabilen Kippschaltung (46) vom RS-Typ in einen ersten Zustand hervorgerufen wird, während dessen Dauer die Steuerung der Umschaltung der Frequenzbereiche jeweils über Rechtecksignale, die durch Betätigung der dritten (7) bzw. der vierten (8) Taste erzeugt werden, freigegeben wird und die Steuerung der Zunahme und Abnahme der Lautstärke durch diese selben Tasten (7, 8) gesperrt ist, und daß das Kippen der ersten RS-Kippschaltung (46) in einen zweiten Zustand, welches durch ein Signal aus einer Demodulationsschaltung (47) des Empfängers gesteuert wird, das den Empfang einer Trägerschwingung mit ausreichender Amplitude anzeigt, das Anhalten des automatischen Suchlaufs, die Sperrung der Bereichsumschaltung und die Freigabe der Lautstärkesteuerung durch Aktivierung der dritten (7) oder der vierten (8) Taste hervorruft.

12. Empfänger nach Anspruch 11, dadurch gekennzeichnet, daß die erste RS-Kippschaltung (46) eine erste Koinzidenzschaltung vom AND-oder NAND-Typ (48) steuert, welche zwischen einen Taktgeber oder ersten astabilen Multivibrator (49) und den Serieneingang (H) eines ersten Binärzählers (50) eingefügt ist, dessen parallele Ausgänge einen ersten Digital/Analog-Umsetzer (51) speisen, welcher die Abstimmspannung liefert, die zur Polarisierung der variablen Kapazitätsdioden der Abstimmkreise des Empfängers in Sperrichtung bestimmt ist, welche während des automatischen Suchlaufs in gleichen Schritten erhöht wird, eine zweite Koinzidenz-Torschaltung (54) steuert, welche zwischen die der dritten Taste (7) zugeordnete Steuerschaltung (17-27) und denjenigen (S) der Steuereingänge (S, R) einer zweiten RS-Kippschaltung (56) eingefügt ist, der das Kippen derselben in einen ersten Zustand steuert, welcher einem der Frequenzbereiche entspricht, eine dritte Koinzidenz-Torschaltung (55) steuert, die zwischen die der vierten Taste (8) zugeordnete Steuerschaltung (18-28) und den anderen Steuereingang (R) der zweiten RS-Kippschaltung (56) eingefügt ist, welcher ihr Kippen in einen zweiten Zustand steuert, welcher dem anderen Frequenzbereich entspricht, wobei diese drei Torschaltungen (48, 54, 55) während des ersten Zustandes der ersten RS-Kippschaltung (46) signaldurchlässig sind und während des zweiten gesperrt sind, und eine vierte Koinzidenz-Torschaltung (58) steuert, welche den Schwingbetrieb eines zweiten astabilen Multivibrators (63) während des zweiten Zustandes der ersten RS-Kippschaltung (46) freigibt und ihn während des ersten sperrt.

13. Empfänger nach Anspruch 12, dadurch gekennzeichnet, daß die Steuerung der Lautstärke während des zweiten Zustandes der ersten Kippschaltung (46) in an sich bekannter Weise mittels eines Aufwärts/Abwärts-Zählers (66) erfolgt, dessen parallele Ausgänge einen zweiten Digital/Analog-Umsetzer (67) steuern, der eine Steuerspannung zu einem Element mit variabler Verstärkung in Abhängigkeit hiervon liefert, das in den Tonfrequenz-Verstärkungsweg des Empfängers eingefügt ist, und daß der zweite Multivibrator (63) über eine Umlenkvorrichtung (59, 60) den Zähleingang (U) eines Aufwärts/Abwärts-Zählers (66) während der Aktivierung der dritten Taste (7) und den Abwärts-Zähleingang (D) desselben während der Aktivierung der vierten Taste (8) speist.

14. Empfänger nach Anspruch 13, dadurch gekennzeichnet, daß die Umlenkvorrichtung (59, 60) zwei Koinzidenz-Torschaltungen (59, 60) mit zwei Eingängen umfaßt, welche jeweils an ihren ersten Eingängen durch die Rechtecksignale gesteuert werden, die durch Aktivierung der dritten (7) bzw. vierten (8) Taste erhalten werden, und an ihren ersten Eingängen ferner mit dem Ausgang einer Integrierstufe (61, 62) verbunden sind, die aus einem logischen Inverter (61) und einem Kondensator (62) gebildet ist, welcher seinen Ausgang mit seinem Eingang verbindet, und deren Ausgänge (64, 65) außer mit dem Aufwärtszähleingang (U) bzw. mit dem Abwärtszähleingang (D) mit zwei Eingängen einer weiteren Koinzidenz-Torschaltung (58) verbunden sind, deren Ausgang mit dem Eingang des Integrators (61, 62) verbunden ist, dergestalt, daß zwei Rückkopplungsschleifen gebildet werden, die durch Aktivierung der dritten (7) bzw. vierten (8) Taste geschlossen werden, wenn alle diese Torschaltungen (59, 60, 58) vom NAND-Typ sind.

15. Empfänger nach Anspruch 14, dadurch gekennzeichnet, daß diese weitere Koinzidenz-Torschaltung (58) drei Eingänge aufweist, wovon einer mit einem der Ausgänge ($\bar{Q}$) der ersten RS-Kippschaltung (46) verbunden ist, damit sie, wenn letztere in ihrem zweiten Zustand ist, signaldurchlässig während der Aktivierungsdauer der dritten (7) oder der vierten (8) Taste ist und während ihres ersten Zustandes gesperrt ist.

16. Empfänger nach einem der Ansprüche 12 bis 15, dadurch gekennzeichnet, daß diejenigen der parallelen Ausgänge des ersten binären Zählers (50), welche die vier höchstwertigen Ziffern liefern, ferner jeweils mit einem Deco-

15

der/Demultiplexer mit vier Eingängen und 16 Ausgängen verbunden sind, die jeweils mit 16 Leuchtdioden verbunden sind, welche eine Abstimmanzeigerampe (12) bilden.

17. Empfänger nach einem der Ansprüche 12 bis 16, dadurch gekennzeichnet, daß diejenigen parallelen Ausgänge des ersten Binärzählers (50), welche die vier höchstwertigen Ziffern liefern, ferner mit einem oder mehreren weiteren Decodern verbunden sind, wovon verschiedene Ausgänge jeweils zwei Generatoren für alphanumerische Zeichen steuern, die jeweils zwei nebeneinanderliegende Siebensegment-Anzeigeeinheiten (13) steuern, welche den Frequenzbereich oder den Empfang von weitreichenden Stationen im Bereich der Langwellen oder Kurzwellen mittels vorbestimmten Symbolen, Buchstaben oder Ziffern anzeigen können.

18. Empfänger nach einem der Ansprüche 12 bis 16, dadurch gekennzeichnet, daß die Doppelanzeigeeinheit (13), wenn die zweite bistabile RS-Kippschaltung (56) den Empfang von frequenzmodulierten Wellen im VHF-Bereich anzeigt, mittels eines weiteren doppelten Typengenerators derart gesteuert wird, daß andere Symbole (FM, MF, UW) angezeigt werden.

# FIG_1

# FIG_2

FIG_3